# EUROPEAN PATENT APPLICATION

(11) **EP 4 654 422 A1**
(43) Date of publication of application: **26.11.2025**
(21) Application number: 23924545.9
(22) Date of filing: 27.02.2023
(51) Int. Cl.: H02J 7/00

(54) **ON-BOARD CHARGER AND VEHICLE**

(71) Applicant: Shinry Technologies Co., Ltd., Shenzhen, Guangdong 518055 (CN)
(72) Inventor: CHENG, Jing, Shenzhen, Guangdong 518055 (CN); JIANG, Baodi, Shenzhen, Guangdong 518055 (CN); SONG, Anguo, Shenzhen, Guangdong 518055 (CN); WU, Renhua, Shenzhen, Guangdong 518055 (CN)
(74) Representative: Mathys & Squire
(86) International application number: PCT/CN2023/078531
(87) International publication number: WO 2024/178564

(57) **Abstract**

An on-board charge and a vehicle are provided in the disclosure. The on-board charger includes a main power board, a power module assembly, and a connecting member. The power module assembly includes a conductive substrate and a field effect transistor (FET). The FET includes an FET body and a pin, the pin of the FET is attached to a surface of the conductive substrate, and the FET is electrically connected to the conductive substrate. The connecting member includes a connecting-member body, a first pin, and a second pin. The connecting-member body is attached to the conductive substrate. One end of the first pin is electrically connected to the connecting-member body and the other end of the first pin is electrically connected to the conductive substrate, and one end of the second pin is electrically connected to the connecting-member body and the other end of the second pin is electrically connected to the main power board. The FET can be further densely arranged and a process cost of the FET is significantly reduced, thereby enabling a miniaturized and lightweight layout of the on-board charger and reducing a process cost of the on-board charger.

## Description

### TECHNICAL FIELD

This disclosure relates to the field of vehicle technology, and in particular, to an on-board charger and a vehicle.

### BACKGROUND

In recent years, with the rapid development of new-energy electric vehicles, energy conservation, environmental protection, safety, and lightweight design have become major development directions for future new-energy electric vehicles. An on-board charger in a new-energy electric vehicle possesses the capability to fully charge a power battery of an electric vehicle in a safe and automatic manner. Based on data provided by a battery management system (BMS), the on-board charger can dynamically adjust charging current or voltage parameters, and execute corresponding actions to complete the charging process.

The interior of the on-board charger includes power devices such as inductors, field effect transistors (FETs), and capacitors. In related technologies, most FETs used in the on-board charger are through-hole FETs. However, the through-hole FETs have characteristics of complex assembly process, high cost, and relatively large volume. The through-hole FETs require to be clamped and secured by means of clamping bars, and insulating thermal-conductive materials such as ceramic sheets need to be assembled between the through-hole FETs and a casing of the on-board charger. The insulating thermal-conductive materials have characteristics of high cost, complex assembly process, and low thermal conductivity. Consequently, the through-hole FETs occupy relatively large space in the on-board charger, resulting in relatively large volume and relatively high cost of the on-board charger. This increases the space occupied by the on-board charger in an electric vehicle, which conflicts with the requirements for lightweight development and cost reduction in electric vehicles.

### SUMMARY

The disclosure provides an on-board charger and a vehicle. In the on-board charger, a pin of a field effect transistor (FET) is attached to a surface of a conductive substrate rather than being connected to a main power board by using a through-hole technology. This eliminates the need for assembly of additional insulating thermal-conductive materials such as ceramic sheets, thereby ensuring sufficient cooling effect for the FET and significantly reducing a process cost of the FET. Therefore, a process cost of the on-board charger can be reduced and a miniaturized and lightweight layout of the on-board charger can be achieved.

In a first aspect, the disclosure provides an on-board charger. The on-board charger includes a main power board, a power module assembly, and a connecting member. The power module assembly includes a conductive substrate and a field effect transistor (FET). The FET includes an FET body and a pin. The pin of the FET is attached to a surface of the conductive substrate. The FET is electrically connected to the conductive substrate. The connecting member includes a connecting-member body, a first pin, and a second pin. The connecting-member body is attached to the conductive substrate. One end of the first pin is electrically connected to the connecting-member body and the other end of the first pin is electrically connected to the conductive substrate. One end of the second pin is electrically connected to the connecting-member body and the other end of the second pin is electrically connected to the main power board.

The power module assembly further includes a casing and a fastener. The casing has a bottom wall and a first sidewall. The bottom wall is connected to the first sidewall in a bent manner. The first sidewall defines a first hole. The conductive substrate defines a second hole. The fastener passes through the first hole and the second hole, and the fastener is configured to fasten the first sidewall and the conductive substrate.

The casing further has a second sidewall and a third sidewall. The second sidewall is connected to the bottom wall in a bent manner. The second sidewall is connected to the first sidewall in a bent manner. The bottom wall, the first sidewall, and the second sidewall cooperatively define an accommodating space. The third sidewall is connected to the bottom wall in a bent manner. The third sidewall is connected to the first sidewall in a bent manner. The accommodating space is partitioned by the third sidewall into a first accommodating sub-space and a second accommodating sub-space. The power module assembly further includes an inductor, a first transformer, and a second transformer. The inductor is accommodated in the first accommodating sub-space. The inductor is configured to receive an input alternating current (AC) signal and filter the input AC signal to obtain a first AC signal. The first transformer is configured to receive the first AC signal and output a first direct current (DC) signal. The first transformer is accommodated in the second accommodating sub-space. The first transformer is electrically connected to the main power board. The second transformer is configured to receive a second DC signal and output a third DC signal. The second transformer is accommodated in the second accommodating sub-space. The second transformer is electrically connected to the main power board. A voltage value of the third DC signal is less than a voltage value of the second DC signal.

The power module assembly further includes a thermal conductive adhesive disposed in the accommodating space. A gap defined in the accommodating space after the inductor, the first transformer, and the second transformer are accommodated in the accommodating space is filled with the thermal conductive adhesive. The thermal conductive adhesive is used to cool the inductor, the first transformer, and the second transformer.

The on-board charger further includes a first cooling member disposed on a surface of the first sidewall facing away from the accommodating space. The conductive substrate is disposed on a surface of the first cooling member facing away from the accommodating space. The first cooling member is configured to cool the power module assembly, and the first cooling member is of a three-dimensional structure.

The on-board charger further includes a box, a cover plate, and a filter capacitor. The box is detachably connected to the cover plate. The box and the cover plate cooperatively define a cavity for accommodating the power module assembly, the main power board, and the connecting member. The filter capacitor is accommodated in the cavity, and is electrically connected to the main power board.

The on-board charger further includes a second cooling member disposed on a surface of the box facing towards the power module assembly. The second cooling member is attached to the power module assembly. The second cooling member is configured to cool the power module assembly.

The on-board charger further includes a first sealing ring and a second sealing ring. The first sealing ring is disposed around the first cooling member and is configured to seal the first cooling member. The second sealing ring is disposed on one side of the second cooling member facing towards the power module assembly and is configured to seal the second cooling member.

The second sealing ring is disposed around the first cooling member and is configured to seal the first cooling member.

The on-board charger further includes a connector disposed on the box. The connector is electrically connected to the main power board and is configured to receive a control signal.

In a second aspect, the disclosure further provides a vehicle. The vehicle includes a vehicle body, an electricity-consumption device carried by the vehicle body, and the on-board charger. The on-board charger is disposed in the vehicle body and is configured to supply power to the electricity-consumption device.

The on-board charger provided in implementations of the disclosure includes the main power board, the power module assembly, and the connecting member. The power module assembly includes the conductive substrate and an FET. The FET includes the FET body and the pin, the pin of the FET is attached to the surface of the conductive substrate, and the FET is electrically connected to the conductive substrate. The connecting member includes the connecting-member body, the first pin, and the second pin. The connecting-member body is attached to the conductive substrate. One end of the first pin is electrically connected to the connecting-member body and the other end of the first pin is electrically connected to the conductive substrate, and one end of the second pin is electrically connected to the connecting-member body and the other end of the second pin is electrically connected to the main power board. The FET is integrated on the conductive substrate, enabling modular assembly of the FET and the conductive substrate, thus improving the mounting efficiency of the on-board charger and facilitating maintenance and replacement of the FET. The FET is integrally disposed on the surface of the conductive substrate, and the conductive substrate is electrically connected to the main power board of the on-board charger via the connecting member, so that complexity of circuit structure of the on-board charger can be reduced, and convenient control and high reliability can be provided. The pin of the FET is attached to the surface of the conductive substrate rather than being connected to the main power board by using a through-hole technology. This eliminates the need for assembly of additional insulating thermal-conductive materials such as ceramic sheets, making the assembly process of the FET simple and feasible. Moreover, the FET can be attached to the conductive substrate for cooling, thereby ensuring sufficient cooling effect for the FET and significantly reducing the process cost of the FET. With sufficient cooling effect ensured, the FET can be further densely arranged, thereby substantially improving a space utilization efficiency of the on-board charger, enabling a miniaturized and lightweight layout of the on-board charger and reducing the process cost of the on-board charger.

### BRIEF DESCRIPTION OF THE DRAWINGS

In order to describe technical solutions of embodiments of the disclosure more clearly, the following will give a brief introduction to the accompanying drawings used for describing implementations. Apparently, the accompanying drawings hereinafter described are some implementations of the disclosure. Based on these drawings, those of ordinary skill in the art can also obtain other drawings without creative effort.
FIG. 1 is a schematic structural view of an on-board charger provided in an embodiment of the disclosure.
FIG. 2 is an exploded schematic perspective structural view of the on-board charger provided in FIG. 1.
FIG. 3 is a schematic structural view of a power module assembly provided in an embodiment of the disclosure.
FIG. 4 is a partially enlarged schematic view of the power module assembly provided in FIG. 3.
FIG. 5 is a partially enlarged schematic view of the power module assembly provided in FIG. 3.
FIG. 6 is an exploded schematic perspective structural view of the power module assembly provided in FIG. 3.
FIG. 7 is an exploded schematic perspective structural view of a part of a power module assembly provided in an embodiment of the disclosure.
FIG. 8 is a schematic structural view of a part of a power module assembly provided in an embodiment of the disclosure.
FIG. 9 is a schematic structural view of a power module assembly provided in an embodiment of the disclosure.
FIG. 10 is an exploded schematic perspective structural view of the power module assembly provided in FIG. 9.
FIG. 11 is an exploded schematic perspective structural view of a power module assembly provided in an embodiment of the disclosure.
FIG. 12 is a schematic structural view of a part of an on-board charger provide in an embodiment of the disclosure.
FIG. 13 is a schematic structural view of a part of an on-board charger provide in an embodiment of the disclosure.
FIG. 14 is a schematic structural view of a vehicle provided in an embodiment of the disclosure.

Description of reference signs: 1 - vehicle, 10 - on-board charger, 20 - vehicle body, 30 - electricity-consumption device, 40 - power battery, 11 - main power board, 12 - power module assembly, 13 - connecting member, 14 - first cooling member, 15 - box, 16 - filter capacitor, 17 - second cooling member, 18 - second sealing ring, 19 - connector, 121 - conductive substrate, 122 - field effect transistor (FET), 123 - casing, 124 - fastener, 125 - inductor, 126 - first transformer, 127 - second transformer, 128 - thermal conductive adhesive, 131 - connecting-member body, 132 - first pin, 133 - second pin, 141 - cooling channel, 142 - first sealing ring, 151 - cavity, 152 - cover plate, 171 - inlet, 172 - outlet, 191 - first connector, 192 - second connector, 193 - third connector, 1211 - second hole, 1221 - FET body, 1222 - pin, 1231 - bottom wall, 1232 - first sidewall, 1233 - second sidewall, 1234 - third sidewall, 1235 - accommodating space, 123a - first hole, 123b - first accommodating sub-space, 123c - second accommodating sub-space.

### DETAILED DESCRIPTION

The following will illustrate technical solutions of embodiments of the disclosure with reference to the accompanying drawings of embodiments of the disclosure. Apparently, embodiments described herein are merely some embodiments, rather than all embodiments, of the disclosure. Based on the embodiments of the disclosure, all other embodiments obtained by those of ordinary skill in the art without creative effort shall fall within the protection scope of the disclosure.

The terms of "embodiment" and "implementation" mentioned in the disclosure means that the specific features, structures, or characteristics described with reference to the embodiment or the implementation may be encompassed in at least one embodiment of the disclosure. The phrase at various locations in the description does not necessarily refer to the same embodiment, or an independent or alternative embodiment exclusive of another embodiment. Those skilled in the art may understand explicitly and implicitly that the embodiments described in the disclosure may be combined with other embodiments.

It may be noted that, the terms "first", "second", and the like used in the description, the claims, and the accompany drawings are to distinguish different objects rather than describe a particular order. In addition, the terms "include", "comprise", and variations thereof are intended to cover non-exclusive inclusion.

In the description, for convenience, wordings indicating directional or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the illustration of the description and simplifying the description, rather than indicating or implying that a referred apparatus or element must have a particular orientation and be constructed and operated in the particular orientation. Therefore, they cannot be understood as limitations on the disclosure. The positional relationships between the constituent elements may be changed as appropriate according to directions for describing the constituent elements. Therefore, appropriate replacements may be made according to situations without being limited to the wordings described in the description.

In the description, unless otherwise specified and defined explicitly, terms "mount", "mutually connect", and "connect" should be understood in a broad sense. For example, a connection may be a fixed connection, or a detachable connection, or an integrated connection. It may be a mechanical connection or an electrical connection. It may be a direct mutual connection, or an indirect connection through middleware, or internal communication between two components. Those of ordinary skills in the art may understand meanings of the above-mentioned terms in the disclosure according to situations.

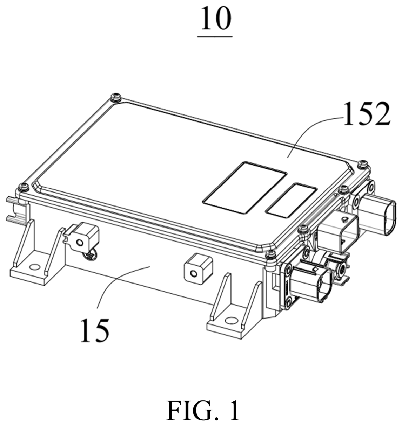

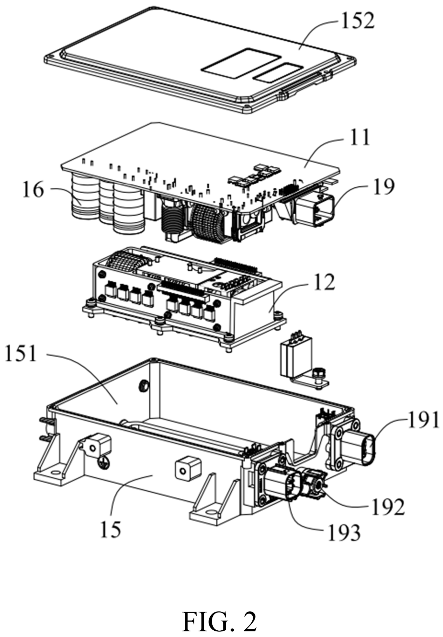

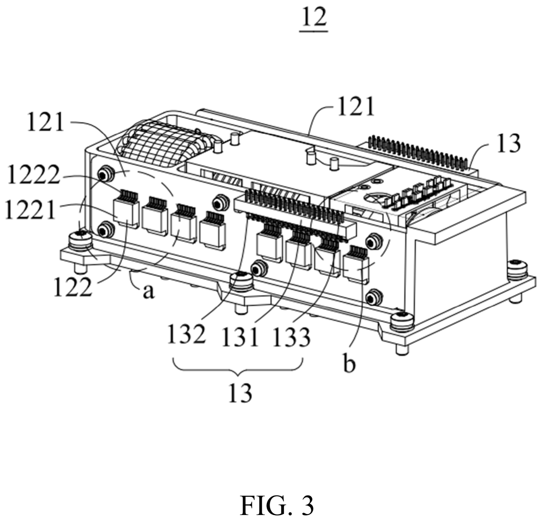

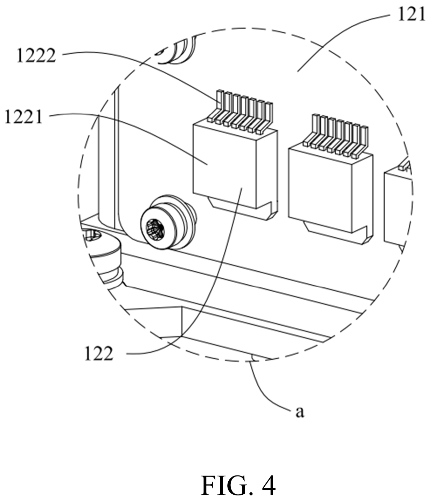

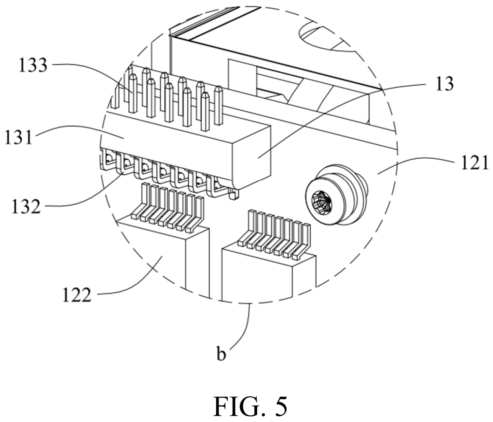

Reference is made to FIG. 1, FIG. 2, FIG. 3, FIG. 4, and FIG. 5. FIG. 1 is a schematic structural view of an on-board charger provided in an embodiment of the disclosure. FIG. 2 is an exploded schematic perspective structural view of the on-board charger provided in FIG. 1. FIG. 3 is a schematic structural view of a power module assembly provided in an embodiment of the disclosure. FIG. 4 is a partially enlarged schematic view of the power module assembly provided in FIG. 3. FIG. 5 is a partially enlarged schematic view of the power module assembly provided in FIG. 3. An on-board charger 10 of embodiments of the disclosure includes a main power board 11, a power module assembly 12, and a connecting member 13. The power module assembly 12 includes a conductive substrate 121 and a field effect transistor (FET) 122. The FET 122 includes an FET body 1221 and a pin 1222. The pin 1222 of the FET 122 is attached to a surface of the conductive substrate 121. The FET 122 is electrically connected to the conductive substrate 121. The connecting member 13 includes a connecting-member body 131, a first pin 132, and a second pin 133. The connecting-member body 131 is attached to the conductive substrate 121. One end of the first pin 132 is electrically connected to the connecting-member body 131 and the other end of the first pin 132 is electrically connected to the conductive substrate 121. One end of the second pin 133 is electrically connected to the connecting-member body 131 and the other end of the second pin 133 is electrically connected to the main power board 11.

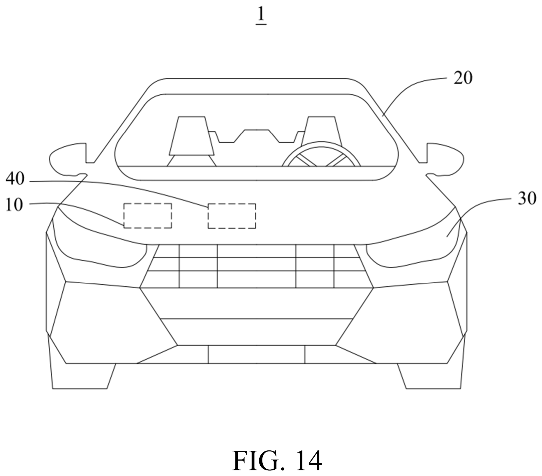

The on-board charger 10 provided in implementations of the disclosure may be applied to a vehicle 1 (FIG. 14). The vehicle 1 may be an electric vehicle. The on-board charger 10 can convert an input alternating current (AC) signal into a high-voltage direct current (DC) signal required by a power battery 40 of the electric vehicle, thereby charging the power battery 40 of the electric vehicle. Moreover, the on-board charger 10 can draw power from the power battery 40 and supply power to electricity-consumption devices in the electric vehicle, such as vehicle lights, display instrument lights, or other electricity-consumption devices. It may be understood that, the on-board charger 10 may also be applied to other products, and the application scenario of the on-board charger 10 should not limit the on-board charger 10 provided in this implementation.

The conductive substrate 121 may be, but is not limited to, made of metal materials such as aluminum or copper, or other composite materials. It may be understood that, the conductive substrate 121 may also be made of other materials with good cooling properties, enabling the FET 122 to be effectively cooled. The conductive substrate 121 may include, but is not limited to, metal wirings disposed thereon to be electrically connected to the FET 122 and the main power board 11.

The FET 122 may be, but is not limited to, a metal oxide semiconductor (MOS) FET. In schematic views of this implementation, the FET 122 is illustrated as a MOSFET for example. A MOSFET is a fundamental unit constituting various complex circuits. The basic structure of a MOSFET mainly includes a source, a drain, and a gate. The source and the drain of the MOSFET are formed by high doping and may be classified into n-type doping (NMOS) or p-type doping (PMOS) depending on device type. The FET 122 provided in this implementation may be, but is not limited to, N-channel enhancement-mode MOSFET or P-channel enhancement-mode MOSFET. The FET 122 may be, but is not limited to, high-power MOSFET, medium-power MOSFET, or low-power MOSFET.

The FET 122 may serve as, but is not limited to, a switch element of the on-board charger 10. In this implementation, the FET 122 is illustrated as the switch element of the on-board charger 10 for example. It may be understood that, the FET 122 may also be configured to control current magnitude, serve as a variable resistor, or serve as a constant current source. The function of the FET 122 should not limit the on-board charger 10 provided in this implementation. When no voltage is applied to the gate of the FET 122, the source and the drain of the FET 122 function as back-to-back diodes with no current flow, placing the FET 122 in a cut-off state. When a voltage is applied at the gate of the FET 122 and the voltage is less than a threshold voltage, an electric field between the gate and substrate of the FET 122 repels holes in a P-type semiconductor. In this case, electrons of an N-type semiconductor as the source and an N-type semiconductor as the drain are attracted out and flock towards the gate. However, electrons are accumulated in the P-type semiconductor between two N-channels due to blocking of an oxide film. As the voltage applied at the gate of the FET 122 increases, electron concentration near the gate increases. When the voltage applied at the gate exceeds the threshold voltage, a N-type semiconductor as an electron channel is formed between the source and the drain of the FET 122. Meanwhile, with a positive voltage applied to the drain, current flows from the drain to the source, and the FET 122 is turned on.

The quantity of the FET(s) 122 may be, but is not limited to, one, two, three, or multiple. The setting of quantity of the FET(s) 122 may be adjusted according to actual application requirements of the on-board charger 10. It may be understood that, the quantity of the FET(s) 122 should not limit the on-board charger 10 provided in this implementation. In schematic views of implementations of the disclosure, multiple FETs 122 are illustrated for example. When the quantity of the FET(s) 122 is multiple, the multiple FETs 122 may be, but are not limited to, spaced apart from one another by a certain distance to facilitate cooling of the FET 122. The distance between any adjacent two of the multiple FETs 122 may be, but is not limited to, pre-calculated based on actual heat power of the on-board charger 10 during operation, or verified through experiments, which is not limited herein. In schematic views of this implementation, the multiple FETs 122 are attached to the conductive substrate 121. Preferably, the conductive substrate 121 may be made of a metal material with relatively good cooling effect, such as an aluminum substrate or a copper substrate, thereby reducing a required cooling distance between the multiple FETs 122. This enables that the multiple FETs 122 can be densely arranged, improving a space utilization efficiency of the on-board charger 10. After ensuring a good cooling effect for the FET 122, electromagnetic compatibility (EMC) between the multiple FETs 122 may be improved through spatial layout modifications, thereby balancing temperature rise and EMC in the circuit of the on-board charger 10 with low-cost design.

The FET body 1221 may be, but is not limited to, attached to the conductive substrate 121, enabling heat generated during operation of the FET 122 to be transferred to the conductive substrate 121 for effective cooling.

The quantity of the pin(s) 1222 may be, but is not limited to, two, three, or multiple. It may be understood that, the quantity of the pin(s) 1222 should not limit the FET 122 provided in this implementation.

The pin 1222 of the FET 122 is attached to the surface of the conductive substrate 121 and is electrically connected to the conductive substrate 121. Specifically, one end of the pin 1222 is electrically connected to the FET body 1221, and the other end of the pin 1222 may be, but is not limited to, connected to the conductive substrate 121 via soldering. Compared with through-hole FETs, the FET 122 provided in this implementation eliminates the need for being clamped and secured by means of additional clamping bars, thereby simplifying the assembly process of the FET 122 and effectively reducing the cost. The through-hole FETs require assembly of insulating thermal-conductive materials such as ceramic sheets for cooling. The insulating thermal-conductive materials have characteristics of high cost, complex assembly process, and low thermal conductivity. Consequently, the through-hole FETs occupy relatively large space in the on-board charger 10, resulting in relatively large volume and relatively high cost of the on-board charger 10. The FET 122 provided in this implementation is attached to the surface of the conductive substrate 121. The conductive substrate 121 may be made of relatively low-cost metal materials with good thermal conductivity. Therefore, assembly of insulating thermal-conductive materials such as ceramic sheets is unnecessary for the FET 122 provided in this implementation, making the assembly process of the FET 122 simple and feasible, achieving a good cooling effect and significantly reducing the cost. The FET 122 provided in this implementation is attached to the conductive substrate 121, further enabling modular assembly of the FET 122 and the conductive substrate 121, facilitating assembly and replacement of the FET 122.

The function of the main power board 11 in the on-board charger 10 may include, but is not limited to, converting an input signal received by the on-board charger 10 into an output signal. The main power board 11 may be, but is not limited to, perpendicular or substantially perpendicular to the conductive substrate 121, thereby saving space and further improving the space utilization efficiency of the on-board charger 10.

The quantity of the connecting member(s) 13 may be, but is not limited to, one, two, three, or multiple. It may be understood that, the quantity of the connecting member(s) 13 may be set according to actual application requirements of the on-board charger 10, and the quantity of the connecting member(s) 13 should not limit the on-board charger 10 provided in this implementation. The connecting-member body 131 may be, but is not limited to, carried by the conductive substrate 121. The connecting-member body 131 may be, but is not limited to, connected to the conductive substrate 121 via soldering, bonding, or snap fit. It may be understood that, the connection method between the connecting-member body 131 and the conductive substrate 121 should not limit the on-board charger 10 provided in this implementation.

The quantity of the first pin(s) 132 may be, but is not limited to, one, two, three, or multiple. It may be understood that, the quantity of the first pin(s) 132 may be adjusted according to actual application requirements of the on-board charger 10, and the quantity of the first pin(s) 132 should not limit the on-board charger 10 provided in this implementation. One end of the first pin 132 is communicatively connected to the connecting-member body 131, and the other end of the first pin 132 is electrically connected to the conductive substrate 121, enabling electrical signals to be transmitted between the connecting-member body 131 and the conductive substrate 121.

The quantity of the second pin(s) 133 may be, but is not limited to, one, two, three, or multiple. It may be understood that, the quantity of the second pin(s) 133 may be adjusted according to actual application requirements of the on-board charger 10, and the quantity of the second pin(s) 133 should not limit the on-board charger 10 provided in this implementation. One end of the second pin 133 is electrically connected to the connecting-member body 131, and the other end of the second pin 133 is electrically connected to the main power board 11, enabling electrical signals to be transmitted between the connecting-member body 131 and the conductive substrate 121. Consequently, electrical signals may be transmitted between the main power board 11, the conductive substrate 121, and the FET 122, allowing the FET 122 to function as a switch element of the on-board charger 10.

In conclusion, the pin 1222 of the FET 122 provided in this implementation is attached to the surface of the conductive substrate 121, and the FET 122 is electrically connected to the conductive substrate 121. One end of the first pin 132 of the connecting member 13 is electrically connected to the connecting-member body 131, and the other end of the first pin 132 is electrically connected to the conductive substrate 121. One end of the second pin 133 of the connecting member 13 is electrically connected to the connecting-member body 131, and the other end of the second pin 133 is electrically connected to the main power board 11. The FET 122 is integrated on the conductive substrate 121, enabling modular assembly of the FET 122 and the conductive substrate 121, thus improving the mounting efficiency of the on-board charger 10 and facilitating maintenance and replacement of the FET 122. The FET 122 is integrally disposed on the surface of the conductive substrate 121, and the conductive substrate 121 is electrically connected to the main power board 11 of the on-board charger 10 via the connecting member 13, so that complexity of circuit structure of the on-board charger 10 can be reduced, and convenient control and high reliability can be provided. The pin 1222 of the FET 122 is attached to the surface of the conductive substrate 121 rather than being connected to the main power board 11 by using a through-hole technology. This eliminates the need for assembly of additional insulating thermal-conductive materials such as ceramic sheets, making the assembly process of the FET 122 simple and feasible. Moreover, the FET 122 can be attached to the conductive substrate 121 for cooling, thereby ensuring sufficient cooling effect for the FET 122 and significantly reducing the process cost of the FET 122. With sufficient cooling effect ensured, the FET 122 can be further densely arranged, thereby substantially improving the space utilization efficiency of the on-board charger 10, enabling a miniaturized and lightweight layout of the on-board charger 10 and reducing the process cost of the on-board charger 10.

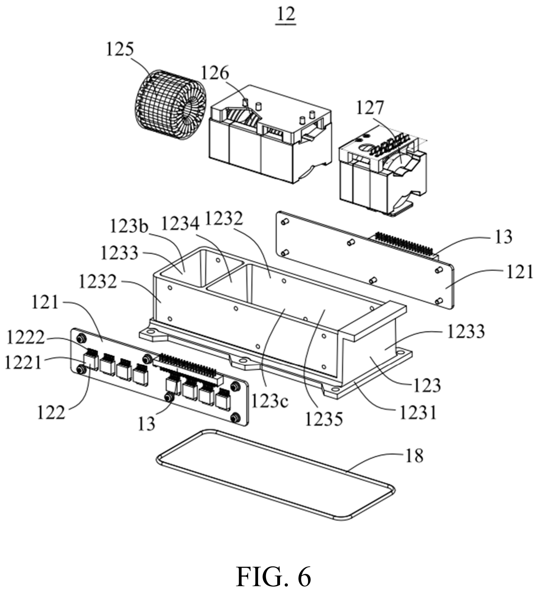

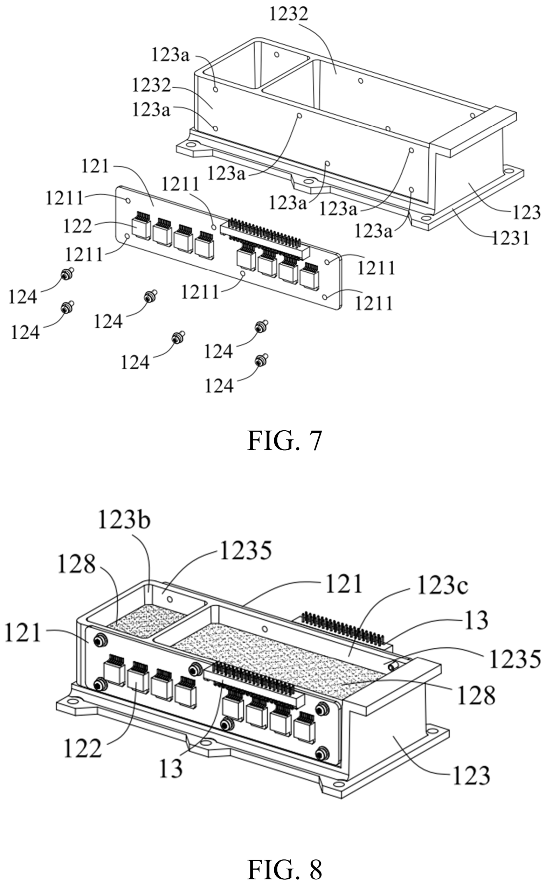

Reference is made to FIG. 3, FIG. 6, and FIG. 7. FIG. 6 is an exploded schematic perspective structural view of the power module assembly provided in FIG. 3. FIG. 7 is an exploded schematic perspective structural view of a part of a power module assembly provided in an embodiment of the disclosure. The power module assembly 12 further includes a casing 123 and a fastener 124. The casing 123 has a bottom wall 1231 and a first sidewall 1232. The bottom wall 1231 is connected to the first sidewall 1232 in a bent manner. The first sidewall 1232 defines a first hole 123a. The conductive substrate 121 defines a second hole 1211. The fastener 124 passes through the first hole 123a and the second hole 1211, and the fastener 124 is configured to fasten the first sidewall 1232 and the conductive substrate 121.

The casing 123 may be, but is not limited to, made of metal, plastic, or other composite materials. It may be understood that, the casing 123 may also be made of materials with relatively good thermal conductivity, and the material of the casing 123 should not limit the on-board charger 10 provided in this implementation.

The bottom wall 1231 is connected to the first sidewall 1232 in a bent manner. A bending angle between the bottom wall 1231 and the first sidewall 1232 may be, but is not limited to, 90° or approximately 90°. It may be understood that, the bending angle between the bottom wall 1231 and the first sidewall 1232 may also be other angles, and the bending angle between the bottom wall 1231 and the first sidewall 1232 should not limit the on-board charger 10 provided in this implementation. The quantity of the first sidewall(s) 1232 may be, but is not limited to, two.

The quantity of the first hole(s) 123a may be, but is not limited to, one, two, three, or multiple. It may be understood that, the quantity of the first hole(s) 123a may be adjusted according to specifications of the on-board charger 10, and the quantity of the first hole(s) 123a should not limit the on-board charger 10 provided in this implementation. The first hole 123a may, but is not limited to, extend through the first sidewall 1232, or not extend through the first sidewall 1232. The shape of the first hole 123a may be, but is not limited to, circular, square, or other irregular shapes, which is not limited herein.

The quantity of the second hole(s) 1211 may be, but is not limited to, one, two, three, or multiple. It may be understood that, the quantity of the second hole(s) 1211 may be adjusted according to specifications of the on-board charger 10, and the quantity of the second hole(s) 1211 should not limit the on-board charger 10 provided in this implementation. The second hole 1211 may, but is not limited to, extend through the conductive substrate 121. The shape of the second hole 1211 may be, but is not limited to, circular, square, or other irregular shapes, which is not limited herein.

The fastener 124 may be, but is not limited to, a screw, a stud and a nut, an adhesive, or a solder. The quantity of the fastener(s) 124 may be, but is not limited to, one, two, three, or multiple. It may be understood that, the quantity of the fastener(s) 124 may be adjusted according to specifications of the on-board charger 10, and the quantity of the fastener(s) 124 should not limit the on-board charger 10 provided in this implementation. The fastener 124 passes through the first hole 123a and the second hole 1211, and is used to fasten the first sidewall 1232 and the conductive substrate 121. In schematic views of this implementation, the fastener 124 is illustrated as a screw for example. The conductive substrate 121 is assembled to the first sidewall 1232 of the casing 123 of the power module assembly 12 via the fastener 124. The assembly method of the conductive substrate 121 is simple, feasible, low in process cost, and highly secure. The conductive substrate 121 may be attached to the first sidewall 1232 of the casing 123, thereby further saving assembly space of the conductive substrate 121 and reducing volume proportion of the on-board charger 10.

Reference is again made to FIG. 3 and FIG. 6. The casing 123 further has a second sidewall 1233 and a third sidewall 1234. The second sidewall 1233 is connected to the bottom wall 1231 in a bent manner. The second sidewall 1233 is connected to the first sidewall 1232 in a bent manner. The bottom wall 1231, the first sidewall 1232, and the second sidewall 1233 cooperatively define an accommodating space 1235. The third sidewall 1234 is connected to the bottom wall 1231 in a bent manner. The third sidewall 1234 is connected to the first sidewall 1232 in a bent manner. The accommodating space 1235 is partitioned by the third sidewall 1234 into a first accommodating sub-space 123b and a second accommodating sub-space 123c. The power module assembly 12 further includes an inductor 125, a first transformer 126, and a second transformer 127. The inductor 125 is accommodated in the first accommodating sub-space 123b. The inductor 125 is configured to receive an input AC signal and filter the input AC signal to obtain a first AC signal. The first transformer 126 is configured to receive the first AC signal and output a first DC signal. The first transformer 126 is accommodated in the second accommodating sub-space 123c. The first transformer 126 is electrically connected to the main power board 11. The second transformer 127 is configured to receive a second DC signal and output a third DC signal. The second transformer 127 is accommodated in the second accommodating sub-space 123c. The second transformer 127 is electrically connected to the main power board 11. A voltage value of the third DC signal is less than a voltage value of the second DC signal.

The quantity of the second sidewall(s) 1233 may be, but is not limited to, two. The second sidewall 1233 is connected to the bottom wall 1231 in a bent manner. A bending angle between the second sidewall 1233 and the bottom wall 1231 may be, but is not limited to, 90° or approximately 90°. It may be understood that, the bending angle between the second sidewall 1233 and the bottom wall 1231 may also be other angles, and the bending angle between the second sidewall 1233 and the bottom wall 1231 should not limit the on-board charger 10 provided in this implementation.

The second sidewall 1233 is connected to the first sidewall 1232 in a bent manner. A bending angle between the second sidewall 1233 and the first sidewall 1232 may be, but is not limited to, 90° or approximately 90°. It may be understood that, the bending angle between the second sidewall 1233 and the first sidewall 1232 may also be other angles, and the bending angle between the second sidewall 1233 and the first sidewall 1232 should not limit the on-board charger 10 provided in this implementation.

The bottom wall 1231, the first sidewall 1232, and the second sidewall 1233 cooperatively define the accommodating space 1235. The shape of the accommodating space 1235 may be, but is not limited to, cuboid or substantially cuboid. It may be understood that, the shape of the accommodating space 1235 may also adopt other designs, and the shape of the accommodating space 1235 should not limit the on-board charger 10 provided in this implementation.

The third sidewall 1234 is connected to the bottom wall 1231 in a bent manner. A bending angle between the third sidewall 1234 and the bottom wall 1231 may be, but is not limited to, 90° or approximately 90°. It may be understood that, the bending angle between the third sidewall 1234 and the bottom wall 1231 may also be other angles, and the bending angle between the third sidewall 1234 and the bottom wall 1231 should not limit the on-board charger 10 provided in this implementation. The accommodating space 1235 is partitioned by the third sidewall 1234 into the first accommodating sub-space 123b and the second accommodating sub-space 123c. The shape of the first accommodating sub-space 123b may be, but is not limited to, cuboid or substantially cuboid. The shape of the second accommodating sub-space 123c may be, but is not limited to, cuboid or substantially cuboid. The volume of the first accommodating sub-space 123b may be less than, equal to, or greater than the volume of the second accommodating sub-space 123c. In schematic views of this implementation, the volume of the first accommodating sub-space 123b being less than the volume of the second accommodating sub-space 123c is illustrated for example. It may be understood that, the volume of the first accommodating sub-space 123b may be adjusted according to actual applications of the on-board charger 10, the volume of the second accommodating sub-space 123c may be adjusted according to actual applications of the on-board charger 10, and a ratio of the volume of the first accommodating sub-space 123b to the volume of the second accommodating sub-space 123c should not limit the on-board charger 10 provided in this implementation.

The inductor 125 may be, but is not limited to, used in the circuit of the on-board charger 10 to filter out electromagnetic interference signals. The inductor 125 may be, but is not limited to, serving as a filter in the circuit of the on-board charger 10. The inductor 125 may be configured to receive the input AC signal of the on-board charger 10 and filter the input AC signal to obtain the first AC signal. The inductor 125 is accommodated in the first accommodating sub-space 123b. A surface of the inductor 125 may be, but is not limited to, provided with a protective cover plate to reduce electromagnetic interference (EMI) received by the inductor 125, and reduce EMI emitted by the inductor 125 to the external world.

The first transformer 126 may be, but is not limited to, a transformer for the on-board charger 10. The first transformer 126 may be configured to receive the first AC signal and output a first DC signal. Therefore, when the on-board charger 10 is applied to an electric vehicle, an AC input electric signal may be converted into a high-voltage DC required by the power battery 40 of the electric vehicle, thereby supplying power to the power battery 40 of the electric vehicle. The first transformer 126 is accommodated in the second accommodating sub-space 123c. The surface of the first transformer 126 may be, but is not limited to, provided with the protective cover plate to reduce EMI received by the first transformer 126, and reduce EMI emitted by the first transformer 126 to the external world. The first transformer 126 is separated from the inductor 125 by the third sidewall 1234, so that mutual EMI between the first transformer 126 and the inductor 125 can be reduced. The first transformer 126 is electrically connected to the main power board 11. The main power board 11 may be, but is not limited to, configured to transmit a control signal to the first transformer 126, and configured to drive the operation of the first transformer 126. The first transformer 126 may be, but is not limited to, electrically connected to the main power board 11 via pins, copper busbars, or conductive pillars, thereby simplifying the design of wiring harness between the first transformer 126 and the main power board 11. Consequently, connection distance and occupied space between the main power board 11 and the first transformer 126 may be reduced, and a highly integrated design of the on-board charger 10 is achieved with characteristics of less connection design of wiring harness, space-saving, and lightweight layout.

The second transformer 127 may be, but is not limited to, a direct current-direct current (DC-DC) transformer. The second transformer 127 may be configured to receive the second DC signal and output the third DC signal, where the voltage value of the third DC signal is less than the voltage value of the second DC signal. When the on-board charger 10 is applied to an electric vehicle, the on-board charger 10 is connected to the power battery 40 of the electric vehicle. The second transformer 127 of the on-board charger 10 can convert high-voltage DC input from the power battery 40 into low-voltage DC, so that the on-board charger 10 can draw power from the power battery 40 and supply power to peripheral devices in the electric vehicle, such as vehicle lights, display instruments. The second transformer 127 is accommodated in the second accommodating sub-space 123c. A surface of the second transformer 127 may be, but is not limited to, provided with a protective cover plate to reduce EMI received by the second transformer 127, and reduce EMI emitted by the second transformer 127 to the external world, ensuring a safe and normal operation of the on-board charger 10. The second transformer 127 is electrically connected to the main power board 11. The main power board 11 may be, but is not limited to, configured to transmit a control signal to the second transformer 127, and configured to drive the operation of the second transformer 127. The second transformer 127 may be, but is not limited to, electrically connected to the main power board 11 via pins, copper busbars, or conductive pillars, thereby simplifying the design of wiring harness between the second transformer 127 and the main power board 11. Consequently, connection distance and occupied space between the main power board 11 and the second transformer 127 may be reduced, a highly integrated design of the on-board charger 10 is achieved with characteristics of less connection design of wiring harness, space-saving, and lightweight layout.

Reference is made to FIG. 3, FIG. 6, and FIG. 8. FIG. 8 is a schematic structural view of a part of a power module assembly provided in an embodiment of the disclosure. The power module assembly 12 further includes a thermal conductive adhesive 128 disposed in the accommodating space 1235. A gap defined in the accommodating space 1235 after the inductor 125, the first transformer 126, and the second transformer 127 are accommodated in the accommodating space 1235 is filled with the thermal conductive adhesive 128. The thermal conductive adhesive 128 is used to cool the inductor 125, the first transformer 126, and the second transformer 127.

The thermal conductive adhesive 128 may be, but is not limited to, made of organic silicone, epoxy adhesive, or composite materials. It may be understood that, the thermal conductive adhesive 128 may also be prepared from other insulating thermal materials with good thermal conductivity and flame retardancy. The material of the thermal conductive adhesive 128 should not limit the on-board charger 10 provided in this implementation.

The gap defined in the accommodating space 1235 after the inductor 125, the first transformer 126, and the second transformer 127 are accommodated in the accommodating space 1235 is filled with the thermal conductive adhesive 128. The thermal conductive adhesive 128 is used to fix and cool the inductor 125, the first transformer 126, and the second transformer 127. The filling of the thermal conductive adhesive 128 may provide a long-term reliable protection for sensitive circuits and components across wide temperature and humidity ranges. The thermal conductive adhesive 128 may be made of materials with excellent electrical insulation properties to withstand environmental contamination and to prevent damage to the inductor 125, the first transformer 126, and the second transformer 127 caused by environmental factors such as stress, vibration, and moisture.

A method for filling the thermal conductive adhesive 128 may be, but is not limited to, first pouring the thermal conductive adhesive 128 into the accommodating space 1235, then assembling the inductor 125, the first transformer 126, and the second transformer 127. Specifically, in the casing 123 of the power module, the thermal conductive adhesive 128 is poured into the accommodating space 1235 of the casing 123, and then the inductor 125, the first transformer 126, and the second transformer 127 are placed in the accommodating space 1235 filled with the thermal conductive adhesive 128. The thermal conductive adhesive 128 is then cured. The method for curing the thermal conductive adhesive 128 may be, but is not limited to, room-temperature curing, heating curing, or other processes. It may be understood that, the curing process of the thermal conductive adhesive 128 should not limit the on-board charger 10 provided in this implementation. The filling volume of the thermal conductive adhesive 128 may be calculated according to specifications of the inductor 125, the first transformer 126, and the second transformer 127, or may be obtained through experiments, which is not limited herein. Compared with the process where the inductor 125, the first transformer 126, and the second transformer 127 are firstly placed in the accommodating space 1235 and then the thermal conductive adhesive 128 is poured into the accommodating space 1235, the process where the thermal conductive adhesive 128 is firstly poured into the accommodating space 1235 may effectively reduce the accumulation of the thermal conductive adhesive 128 in the accommodating space 1235, and reduce the generation of bubbles in the thermal conductive adhesive 128, thereby facilitating the filling process of the thermal conductive adhesive 128. Moreover, the thermal conductive adhesive 128 may more closely conform to the inductor 125, the first transformer 126, and the second transformer 127, thereby providing a good cooling effect and a long-term stable protection for the inductor 125, the first transformer 126, and the second transformer 127.

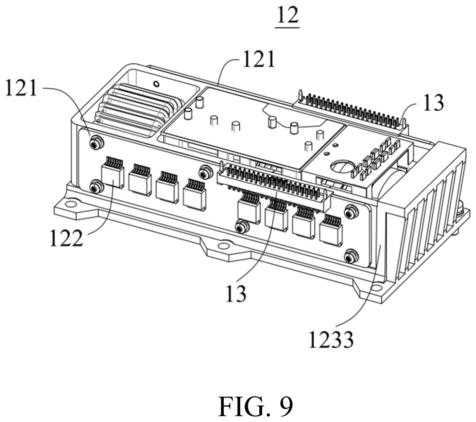

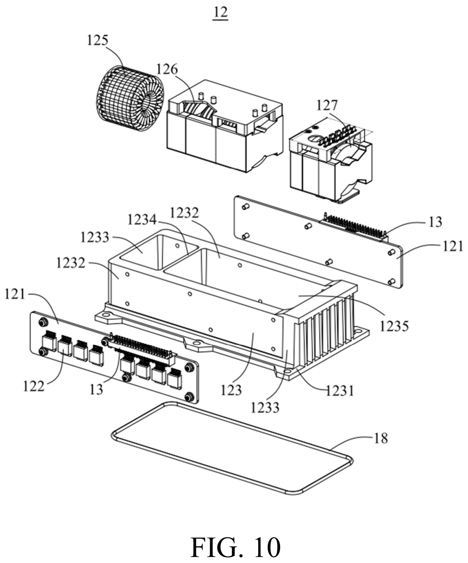

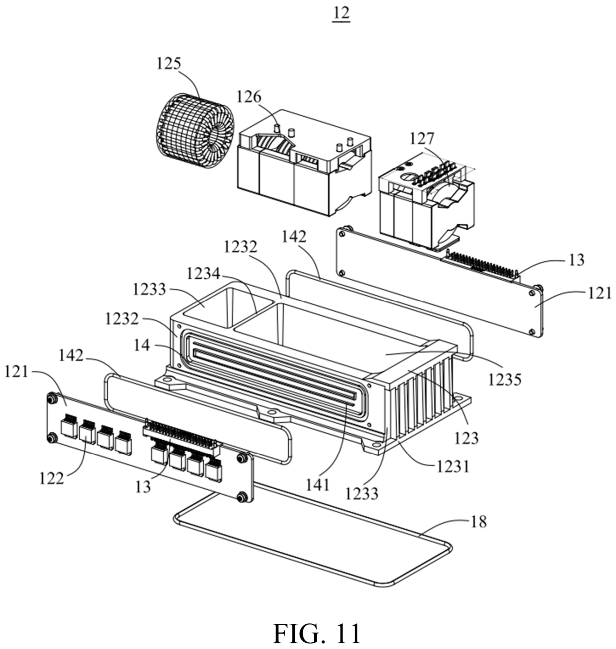

Reference is made to FIG. 9, FIG. 10, and FIG. 11. FIG. 9 is a schematic structural view of a power module assembly provided in an embodiment of the disclosure. FIG. 10 is an exploded schematic perspective structural view of the power module assembly provided in FIG. 9. FIG. 11 is an exploded schematic perspective structural view of the power module assembly provided in an embodiment of the disclosure. The on-board charger 10 further includes a first cooling member 14 disposed on a surface of the first sidewall 1232 facing away from the accommodating space 1235. The conductive substrate 121 is disposed on a surface of the first cooling member 14 facing away from the accommodating space 1235. The first cooling member 14 is configured to cool the power module assembly 12 and the conductive substrate 121, and the first cooling member 14 is of a three-dimensional structure.

The first cooling member 14 may include, but is not limited to, a cooling channel 141. The cooling channel 141 is configured for convey of a cooling medium. The cooling medium may be, but is not limited to, water, oil, other cooling liquids, or cooling gases. The first cooling member 14 is configured to cool the power module assembly 12. During operation, the power module assembly 12 may generate a relatively large amount of heat. Inadequate heat transfer may cause damage to the power module assembly 12 and compromise operational safety of the power module assembly 12. The quantity of the first cooling member(s) 14 may be, but is not limited to, one, two, or multiple. It may be understood that, the quantity of the first cooling member(s) 14 should not limit the on-board charger 10 provided in this implementation.

In an implementation of the disclosure, the first cooling member 14 may be, but is not limited to, of a three-dimensional water channel structure (FIG. 11). Specifically, the cooling channel 141 of the first cooling member 14 may be exposed on a surface of the first sidewall 1232. When the first cooling member 14 is configured as a three-dimensional structure, the first cooling member 14 may be, but is not limited to, integrally formed with the first sidewall 1232 or directly machined on the first sidewall 1232. When the first cooling member 14 is directly machined on the first sidewall 1232, modular manufacturing of the power module assembly 12 and the first cooling member 14 may be achieved, thereby improving production and mounting efficiency and reducing material usage and the cost.

The conductive substrate 121 is disposed on the surface of the first cooling member 14 facing away from the accommodating space 1235. The conductive substrate 121 may serve directly as, but is not limited to, a cover plate for the first cooling member 14, eliminating the need for an additional cover plate on the first cooling member 14 and the need for locking assembling, thereby reducing a manufacturing cost of the on-board charger 10. The first cooling member 14 may, but is not limited to, cool both the power module assembly 12 and the conductive substrate 121, thereby effectively enhancing the cooling efficiency of the on-board charger 10. The conductive substrate 121 may be, but is not limited to, attached to the surface of the first cooling member 14 facing away from the accommodating space 1235, thereby providing a better cooling effect for the on-board charger 10. Moreover, a higher power density of the on-board charger 10 is ensured, and a highly integrated design of the on-board charger 10 is achieved.

In implementations of the disclosure, the quantity of the first sidewall(s) 1232 is illustrated as two for example. It may be understood that, the first cooling member 14 may be, but is not limited to, disposed on one or two of the first sidewalls 1232, and the first cooling member 14 may be disposed according to actual cooling requirements of the on-board charger 10.

The first cooling member 14 may be configured to cool the conductive substrate 121 and other components of the power module assembly 12, which provides a more sufficient cooling effect for the power module assembly 12 and provides a good cooling effect for the conductive substrate 121 and the FET 122. Therefore, a safe and normal operation of the on-board charger 10 is ensured, and a further miniaturized layout of the on-board charger 10 may be achieved.

Reference is again made to FIG. 1, FIG. 2, and FIG. 3. The on-board charger 10 further includes a box 15 and a cover plate 152. The box 15 is detachably connected to the cover plate 152. The box 15 and the cover plate 152 cooperatively define a cavity 151 for accommodating the power module assembly 12, the main power board 11, and the connecting member 13. The on-board charger 10 further includes a filter capacitor 16 accommodated in the cavity 151 of the box 15, and the filter capacitor 16 is electrically connected to the main power board 11.

The box 15 may be, but is not limited to, made of metal, plastic, or composite materials. It may be understood that, the box 15 may also be made of other materials, and the material of the box 15 should not limit the box 15 provided in this implementation. The shape of the box 15 may be, but is not limited to, cuboid or substantially cuboid. It may be understood that, the box 15 may be of other shapes, and the shape of the box 15 should not limit the box 15 provided in this implementation. The cover plate 152 is detachably connected to the box 15. The cover plate 152 and the box 15 may be, but is not limited to, connected via studs and nuts. It may be understood that, the cover plate 152 and the box 15 may be detachably connected through other connection methods, and the connection method between the cover plate 152 and the box 15 should not limit the on-board charger 10 provided in this implementation. The cover plate 152 may be, but is not limited to, made of metal, plastic, or composite materials, and the material of the cover plate 152 may be, but is not limited to, identical to the material of the box 15 or different from the material of the box 15, which is not limited herein.

The cavity 151 is configured to accommodate the power module assembly 12, the main power board 11, and the connecting member 13. The power module assembly 12 and the main power board 11 are accommodated in the cavity 151, and the power module assembly 12 may be, but is not limited to, attached to one side of the main power board 11. The power module assembly 12 may be, but is not limited to, electrically connected to the main power board 11 via pins, copper busbars, or conductive pillars, thereby simplifying the design of wiring harness between the power module assembly 12 and the main power board 11. In this way, the design of wiring harness is simplified, the distance between the power module assembly 12 and the main power board 11 is reduced, and a highly integrated layout of the on-board charger 10 is achieved.

The filter capacitor 16 enables the filtered output voltage to be a stable DC voltage. The operational principle of the filter capacitor is as follows: when a rectified voltage is higher than the voltage across the filter capacitor 16, the filter capacitor performs the charge, and when a rectified voltage is lower than the voltage across the filter capacitor 16, the filter capacitor performs the discharge. Through the charge-discharge process, the output voltage is maintained substantially stable. The filter capacitor 16 may be, but is not limited to, electrically connected to the main power board 11 via pins, copper busbars, or conductive pillars, thereby simplifying the design of wiring harness between the filter capacitor 16 and the main power board 11. Consequently, connection distance and occupied space between the main power board 11 and the filter capacitor 16 may be reduced, a highly integrated design of the on-board charger 10 is achieved with characteristics of less connection design of wiring harness, space-saving, and lightweight layout.

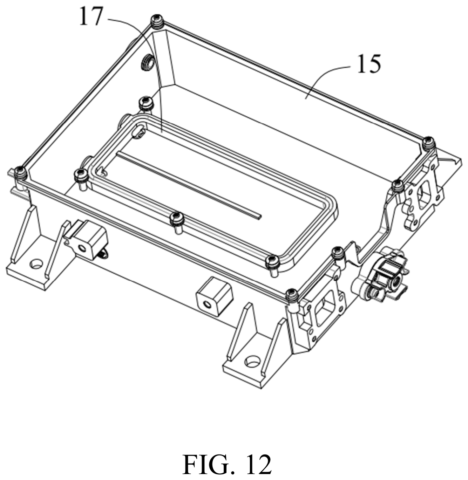

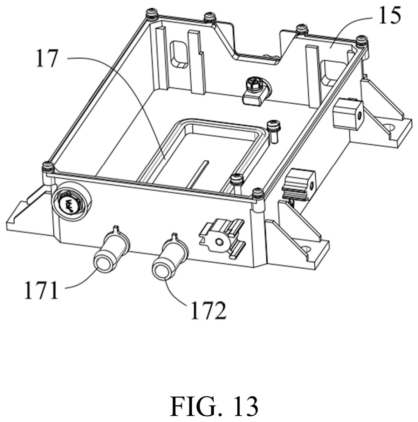

Reference is made to FIG. 2, FIG. 12, and FIG. 13. FIG. 12 is a schematic structural view of a part of an on-board charger provide in an embodiment of the disclosure. FIG. 13 is a schematic structural view of a part of an on-board charger provide in an embodiment of the disclosure. The on-board charger 10 further includes a second cooling member 17 disposed on a surface of the box 15 facing towards the power module assembly 12. The second cooling member 17 is attached to the power module assembly 12. The second cooling member 17 is configured to cool the power module assembly 12.

The quantity of the second cooling member(s) 17 may be, but is not limited to, one, two, three, or multiple. It may be understood that, the quantity of the second cooling member(s) 17 may be adjusted according to actual cooling requirements of the on-board charger 10, and the quantity of the second cooling member(s) 17 should not limit the on-board charger 10 provided in this implementation.

The box 15 further includes an inlet 171 and an outlet 172. The inlet 171 communicates with the second cooling member 17, and is configured for the input of the cooling medium to the second cooling member 17. The outlet 172 communicates with the second cooling member 17, and is configured for the output of the cooling medium from the second cooling member 17. The inlet 171 and the outlet 172 may be, but are not limited to, connected to a cooling system of the vehicle 1 or connected to an independent cooling medium source, which is not limited herein.

The second cooling member 17 may be, but is not limited to, disposed corresponding to the power module assembly 12. That is, an area of a surface of the second cooling member 17 facing away from the box 15 may be, but is not limited to, equal or substantially equal to an area of a surface of the power module assembly 12, so that the second cooling member 17 can cool the power module assembly 12. It may be understood that, the area of the surface of the second cooling member 17 facing away from the box 15 may also be larger than the area of the surface of the power module assembly 12, so that the second cooling member 17 can cool the power module assembly 12, the filter capacitor 16, and other electrical components in the on-board charger 10, thereby achieving a more sufficient cooling effect for the on-board charger 10.

The second cooling member 17 is attached to the power module assembly 12, and the second cooling member 17 can cool the power module assembly 12. During operation, the power module assembly 12 generates a relatively large amount of heat, which may cause damage and impair normal operation of the power module assembly 12. A good cooling effect for the power module assembly can prevent the power module assembly 12 from overheating, thereby ensuring a safe and normal operation of the on-board charger 10.

Reference is again made to FIG. 2, FIG. 9, FIG. 11, and FIG. 12. The on-board charger 10 further includes a first sealing ring 142 and a second sealing ring 18. The first sealing ring 142 is disposed around the first cooling member 14 and is configured to seal the first cooling member 14. The second sealing ring 18 is disposed on one side of the second cooling member 17 facing towards the power module assembly 12 and is configured to seal the second cooling member 17.

The first sealing ring 142 may be, but is not limited to, made of rubber, plastic, or other composite materials. It may be understood that, the material of the first sealing ring 142 should not limit the on-board charger 10 provided in this implementation. The quantity of the first sealing ring(s) 142 may be, but is not limited to, one, two, or multiple. It may be understood that, the quantity of the first sealing ring(s) 142 may be other values and should not limit the on-board charger 10 provided in this implementation. The first sealing ring 142 may be, but is not limited to, attached to a periphery of the first cooling member 14, and is configured to seal the first cooling member 14, thereby preventing overflow of the cooling medium in the first cooling member 14 and ensuring a safe operation of the on-board charger 10.

The second sealing ring 18 may be, but is not limited to, made of rubber, plastic, or other composite materials. It may be understood that, the material of the second sealing ring 18 should not limit the on-board charger 10 provided in this implementation. The quantity of the second sealing ring(s) 18 may be, but is not limited to, one, two, or multiple. It may be understood that, the quantity of the second sealing ring(s) 18 may be other values and should not limit the on-board charger 10 provided in this implementation. The second sealing ring 18 is disposed on one side of the second cooling member 17 facing towards the power module assembly 12. The second sealing ring 18 may be attached to a periphery of the power module assembly 12. The second sealing ring 18 is configured to seal the second cooling member 17 and prevent overflow of the cooling medium in the second cooling member 17, thereby ensuring the cooling effect for the power module assembly 12 and a safe and normal operation of the on-board charger 10.

Reference is again made to FIG. 2. The on-board charger 10 further includes a connector 19 disposed on the box 15. The connector 19 is electrically connected to the main power board 11 and is configured to receive a control signal.

The connector 19 may be, but is not limited to, a signal connector. The connector 19 may maintain real-time communication with a battery management system (BMS) of the vehicle 1, and the connector 19 is configured to receive a control signal. The connector 19 is electrically connected to the main power board 11. The connector 19 may be, but is not limited to, electrically connected to the main power board 11 via copper busbars or conductive pillars. It may be understood that, the connection method between the connector 19 and the main power board 11 should not limit the on-board charger 10 provided in this implementation.

The on-board charger 10 may further include a first connector 191. The first connector 191 may be, but is not limited to, a high voltage direct current (HVDC) connector 19. The HVDC connector 19 may be connected to a high-voltage battery of the vehicle 1. The first connector 191 may be, but is not limited to, connected to the box 15 via soldering, bonding, or screw fixing. The first connector 191 is electrically connected to the main power board 11. The first connector 191 may be, but is not limited to, electrically connected to the main power board 11 via pins, copper busbars, or conductive pillars.

The on-board charger 10 may further include a second connector 192. The second connector 192 may be, but is not limited to, a DC12V connector 19. The DC12V connector 19 may be connected to a low-voltage battery of the vehicle 1. The second connector 192 may be, but is not limited to, connected to the box 15 via soldering, bonding, or screw fixing. The second connector 192 is electrically connected to the main power board 11. The connector 19 may be, but is not limited to, electrically connected to the main power board 11 via pins, copper busbars, or conductive pillars.

The on-board charger 10 may further include a third connector 193. The third connector 193 may be, but is not limited to, a high voltage alternating current (HVAC) connector 19. The HVAC connector 19 may be connected to a charging chamber of the vehicle 1. The third connector 193 may be, but is not limited to, connected to the box 15 via soldering, bonding, or screw fixing. The third connector 193 is electrically connected to the main power board 11. The third connector 193 may be, but is not limited to, electrically connected to the main power board 11 via pins, copper busbars, or conductive pillars.

A highly integrated design is employed between the connector 19, the first connector 191, the second connector 192, the third connector 193, and the main power board 11, simplifying the connection design of wiring harness, thereby significantly improving the space utilization efficiency of the on-board charger 10.

Implementations of the disclosure further provide a vehicle 1. The vehicle 1 includes a vehicle body 20, an electricity-consumption device 30, and the on-board charger 10. The electricity-consumption device 30 is carried by the vehicle body 20. The on-board charger 10 is disposed in the vehicle body 20 and is configured to supply power to the electricity-consumption device 30.

Reference is made to FIG. 14, which is a schematic structural view of a vehicle provided in an embodiment of the disclosure. The vehicle 1 may be an electric vehicle. The vehicle body 20 may be, but is not limited to, a frame of the vehicle 1. The electricity-consumption device 30 may be, but is not limited to, vehicle lights or display instruments. The vehicle 1 may include the power battery 40. The on-board charger 10 can be configured to receive the first AC signal and output the first DC signal, so that the on-board charger 10 may convert an input AC signal into a high-voltage DC required by the power battery 40, thereby supplying power to the power battery 40. The on-board charger 10 is connected to the power battery 40 of the electric vehicle, and the on-board charger 10 can convert high-voltage DC input from the power battery 40 into low-voltage DC, thereby drawing power from the power battery 40 and supplying power to the electricity-consumption device 30 of the vehicle 1.

In the on-board charger 10 provided in this implementation, the pin 1222 of the FET 122 is attached to the surface of the conductive substrate 121, and the FET 122 is electrically connected to the conductive substrate 121. The pin 1222 of the FET 122 is attached to the surface of the conductive substrate 121 rather than being connected to the main power board 11 by using a through-hole technology. This eliminates the need for assembly of additional insulating thermal-conductive materials such as ceramic sheets, making the assembly process of the FET 122 simple and feasible. Moreover, the FET 122 can be attached to the conductive substrate 121 for cooling, thereby ensuring sufficient cooling effect for the FET 122 and significantly reducing the process cost of the FET 122. With sufficient cooling effect ensured, the FET 122 can be further densely arranged, thereby substantially improving the space utilization efficiency of the on-board charger 10, enabling a miniaturized and lightweight layout of the on-board charger 10 and reducing the process cost of the on-board charger 10. Therefore, the manufacturing cost of the vehicle 1 is reduced, and the space utilization efficiency of the interior of the vehicle 1 is effectively improved.

The above are some implementations of the disclosure. It should be pointed out that those skilled in the art can make several improvements and modifications without departing from principles of the disclosure. These improvements and modifications may be also regarded as the protection scope of the disclosure.

## Claims

1. An on-board charger, comprising:
a main power board;
a power module assembly comprising a conductive substrate and a field effect transistor (FET), wherein the FET comprises an FET body and a pin, the pin of the FET is attached to a surface of the conductive substrate, and the FET is electrically connected to the conductive substrate; and
a connecting member comprising a connecting-member body, a first pin, and a second pin, wherein the connecting-member body is attached to the conductive substrate, one end of the first pin is electrically connected to the connecting-member body and the other end of the first pin is electrically connected to the conductive substrate, and one end of the second pin is electrically connected to the connecting-member body and the other end of the second pin is electrically connected to the main power board.

2. The on-board charger of claim 1, wherein the power module assembly further comprises:
a casing, wherein the casing has a bottom wall and a first sidewall, the bottom wall is connected to the first sidewall in a bent manner, the first sidewall defines a first hole, and the conductive substrate defines a second hole; and
a fastener, wherein the fastener passes through the first hole and the second hole, and the fastener is configured to fasten the first sidewall and the conductive substrate.

3. The on-board charger of claim 2, wherein the casing further has a second sidewall and a third sidewall, the second sidewall is connected to the bottom wall in a bent manner, the second sidewall is connected to the first sidewall in a bent manner, and the bottom wall, the first sidewall, and the second sidewall cooperatively define an accommodating space;
the third sidewall is connected to the bottom wall in a bent manner, the third sidewall is connected to the first sidewall in a bent manner, and the accommodating space is partitioned by the third sidewall into a first accommodating sub-space and a second accommodating sub-space;
the power module assembly further comprises an inductor, a first transformer, and a second transformer, wherein the inductor is accommodated in the first accommodating sub-space, the inductor is configured to receive an input alternating current (AC) signal and filter the input AC signal to obtain a first AC signal;
the first transformer is configured to receive the first AC signal and output a first direct current (DC) signal, the first transformer is accommodated in the second accommodating sub-space, and the first transformer is electrically connected to the main power board; and
the second transformer is configured to receive a second DC signal and output a third DC signal, the second transformer is accommodated in the second accommodating sub-space, and the second transformer is electrically connected to the main power board, wherein a voltage value of the third DC signal is less than a voltage value of the second DC signal.

4. The on-board charger of claim 3, wherein the power module assembly further comprises a thermal conductive adhesive disposed in the accommodating space, a gap defined in the accommodating space after the inductor, the first transformer, and the second transformer are accommodated in the accommodating space is filled with the thermal conductive adhesive, and the thermal conductive adhesive is used to cool the inductor, the first transformer, and the second transformer.

5. The on-board charger of claim 3, further comprising a first cooling member disposed on a surface of the first sidewall facing away from the accommodating space, wherein the conductive substrate is disposed on a surface of the first cooling member facing away from the accommodating space, the first cooling member is configured to cool the power module assembly, and the first cooling member is of a three-dimensional structure.

6. The on-board charger of claim 5, further comprising:
a box and a cover plate, wherein the box is detachably connected to the cover plate, the box and the cover plate cooperatively define a cavity for accommodating the power module assembly, the main power board, and the connecting member; and
a filter capacitor accommodated in the cavity, and electrically connected to the main power board.

7. The on-board charger of claim 6, further comprising a second cooling member disposed on a surface of the box facing towards the power module assembly, wherein the second cooling member is attached to the power module assembly, and the second cooling member is configured to cool the power module assembly.

8. The on-board charger of claim 7, further comprising a first sealing ring and a second sealing ring, wherein the first sealing ring is disposed around the first cooling member and is configured to seal the first cooling member; and
the second sealing ring is disposed on one side of the second cooling member facing towards the power module assembly and is configured to seal the second cooling member.

9. The on-board charger of claim 6, further comprising a connector disposed on the box, wherein the connector is electrically connected to the main power board and is configured to receive a control signal.

10. A vehicle, comprising:
a vehicle body;
an electricity-consumption device carried by the vehicle body; and
the on-board charger of any one of claims 1 to 9, wherein the on-board charger is disposed in the vehicle body and is configured to supply power to the electricity-consumption device.
